# EUROPÄISCHE PATENTSCHRIFT

(11) **EP 3 171 188 B1**
(45) Veröffentlichungstag und Bekanntmachung des Hinweises auf die Patenterteilung: **10.04.2019**
(21) Anmeldenummer: 15822841.1
(22) Anmeldetag: 25.06.2015
(51) Int. Cl.: G01R 33/035

(54) **SUPERLEITENDE QUANTENINTERFERENZVORRICHTUNG MIT EINEM EINZIGEN BETRIEBSVERSTÄRKERMAGNETSENSOR**
SUPERCONDUCTING QUANTUM INTERFERENCE DEVICE USING SINGLE OPERATIONAL AMPLIFIER MAGNETIC SENSOR
DISPOSITIF D'INTERFÉRENCE QUANTIQUE SUPRACONDUCTEUR UTILISANT UN CAPTEUR MAGNÉTIQUE À AMPLIFICATEUR OPÉRATIONNEL UNIQUE

(30) Priorität: 18.07.2014 CN 201410344300
(43) Veröffentlichungstag der Anmeldung: 24.05.2017
(73) Patentinhaber: Shanghai Institute Of Microsystem And Information Technology, Chinese Academy Of Sciences, Shanghai 200050 (CN); Forschungszentrum Jülich GmbH, 52425 Jülich (DE)
(72) Erfinder: WANG, Yongliang, Shanghai 200050 (CN); ZHANG, Yi, 52428 Jülich (DE); CHANG, Kai, Shanghai 200050 (CN); KRAUSE, Hans-Joachim, 52499 Baesweiler (DE); XU, Xiaofeng, Shanghai 200050 (CN); QIU, Yang, Shanghai 200050 (CN)
(74) Vertreter: Gille Hrabal
(86) Internationale Anmeldenummer: PCT/CN2015/082289
(87) Internationale Veröffentlichungsnummer: WO 2016/008352

(56) Entgegenhaltungen:
- EP-A1- 2 476 005
- WO-A1-2011/029471
- CN-A- 102 426 343
- CN-A- 103 616 650
- CN-A- 104 198 961
- CN-U- 203 595 799
- CN-U- 203 720 338
- CN-U- 203 720 338
- DE-A1-102013 016 739
- JP-A- H 075 233
- JP-A- H 075 233
- JP-A- H0 798 370
- KR-A- 20000 067 035

## Beschreibung

Die vorliegende Erfindung betrifft einen SQUID-Magnetfeldsensor mit einem einzelnen Operationsverstärker, insbesondere eine SQUID-Ausleseschaltung, und gehört zur elektrischen Schaltungstechnik.

Ein SQUID-Magnetfeldsensor, der mit einer supraleitenden Quanteninterferenzeinheit (Superconducting Quantum Interference Device in Englisch, als SQUID abgekürzt) aufgebaut wird, ist heutzutage bekannt als der empfindlichste magnetische Sensor. Derartiger Sensor wird weit in Anwendungsgebieten bezüglich der Ermittlung von schwachen Magnetfeldern, wie zum Beispiel von Biomagnetfeldern, von Erdmagnetfeld-Unnormal, von sehr geringen MRT-Feldern usw., eingesetzt. Die Empfindlichkeit der Ermittlung von Magnetfeldern des SQUID-Magnetfeldsensors kann bereits auf die Größenordnung von Femtotesla (10⁻¹⁵ T) erreichen. Deshalb ist er sehr wichtig für die Forschung und die Ermittlung eines extrem schwachen Magnetfelds.

Ein Gleichstrom-SQUID (auch als DC-SQUID bezeichnet) ist ein supraleitender Ring, der durch zwei parallel geschalteten supraleitenden Josephson-Kontakte ausgebildet ist. Wenn die Anschlussleitungen an zwei Enden der Josephson-Kontakte ausgeführt werden, wird ein elektrisches Bauelement mit zwei Anschlüssen ausgebildet. Wenn an zwei Anschlüssen eines SQUID ein gewisser Biasstrom aufgebracht wird, basierend auf dem Effekt der supraleitenden Quantisierung und dem Josephson-Effekt, ändert sich eine an den beiden Anschlüssen erzeugten Spannung mit einem externen magnetisch-induktiven Fluss im supraleitenden Ring. Die von dem SQUID ausgegebene Spannung hat ein nichtlineares Verhältnis zum seinem ermittelten Magnetfluss, ist es daher nicht möglich, die Größe des ermittelten Magnetflusses unmittelbar durch die Messung der Spannung an den beiden Anschlüssen des SQUID zu erhalten. So ist ein SQUID-Magnetfeldsensor in der Praxis durch eine Flux-Locked-Loop (im Folgenden als FLL abgekürzt) zu realisieren, die aus einem SQUID und einem Operationsverstärker besteht. Die Flux-Locked-Loop ist auch als SQUID-Ausleseschaltung genannt.

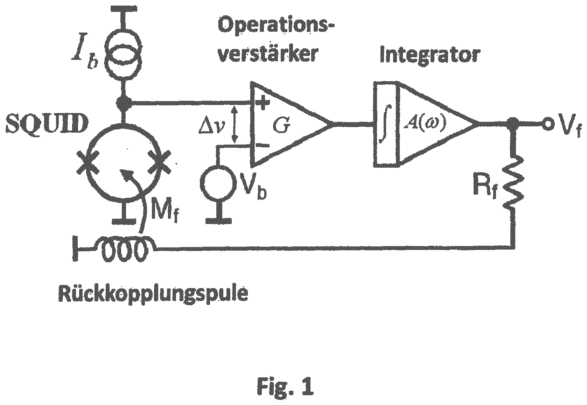

Eine typische SQUID-FLL aus einer Druckschrift [D.Drung and M.Mück, The SQUID Handbook, vo1. I, J. Clarke and A. I. Braginski, Ed. Weinheim: Wiley-VCH, pp.128-155, 2006.] ist wie in der Fig.1 dargestellt, wobei ein gewisser Biasstrom I_{b} zunächst in das SQUID eingebracht wird, so dass es eine maximale Magnetfluss-Spannung-Übertragungsrate besitzen kann, und ein Spannungssignal des SQUID in einen Vorverstärker eingebracht wird, um sich zu verstärken. Zugleich wird eine Biasspannung V_{b} so eingestellt, dass der Gleichanteil der vom SQUID bei der maximalen Magnetfluss-Spannung-Übertragungsrate ausgegeben Spannung gleich Null ist. Dabei wird der Zustand in dem Moment, wo das SQUID den Biasstrom I_{b} und die Biasspannung V_{b} sowie den aufgeladenen Magnetfluss Φₐ hat, als Arbeitspunkt bezeichnet. Die Ausgabe des Vorverstärkers wird in einen Integrator eingebracht, um sich zu integrieren, und die Ausgabe des Integrators dient zum Betreiben eines Rückkopplungswiderstands, um einen Rückkopplungsstrom in eine Rückkopplungsspule einzuführen. Der durch die Gegeninduktion zwischen der Rückkopplungsspule und dem SQUID erzeugte Rückkopplungsmagnetfluss wird somit in das SQUID gekoppelt.

Im Folgenden wird die Funktionsweise einer Flux-Locked-Loop beschrieben: wenn die Flux-Locked-Loop sich im Arbeitspunkt des SQUID stabil hält, wird bei einer Änderung des ermittelten Magnetflusses ΔΦ eine vom Arbeitspunkt abweichende Spannungsänderung Δv an den Anschlüssen des SQUID erzeugt. Nachdem die Spannungsänderung Δv durch einen Vorverstärker verstärkt ist, wird sie in einen Integrator eingeführt zu integrieren, um die Ausgangsspannung des Integrators einzustellen. Durch die Einstellung des Rückkopplungs- magnetflusses über einen Rückkopplungswiderstand und eine Rückkopplungsspule wird die vorgenannte von Außen eingegebene Magnetflussänderung aufgehoben, so dass die Spannung, die vom SQUID im Arbeitspunkt in den Integrator eingegeben wird, gleich Null ist, der Integrator hört somit auf zu integrieren und die Stabilität der Flux-Locked-Loop wird wiederhergestellt. Der stabile Zustand im Arbeitspunkt wird als die Verriegelung einer Ausleseschaltung bezeichnet. Unter dem verriegelten Zustand verhält sich die von der Flux-Locked-Loop ausgegebene Spannung V_{f} proportional zu der externen magnetisch-induktiven Flussänderung im SQUID [D.Drung "High-Tc and low-Tc dc SQUID electronics" Supercond. Sci. Technol. 161320-1336 (2003)], nämlich V_{f}=ΔΦ·R_{f}/M_{f}, wobei ΔΦ die mit SQUID ermittelte Magnetflussänderung ist, R_{f} der Rückkopplungswiderstand ist, M_{f} die Gegeninduktivität zwischen der Rückkopplungsspule und dem SQUID ist.

Bei der Ausstattung von elektrischen Schaltungen, in einer herkömmlichen SQUID-FLL wird in der Regel ein Vorverstärker eingesetzt, um ein geringes Spannungssignal des SQUID rauscharm zu verstärken, und das verstärkte Signal wird dann in einen Integrator eingeführt zu integrieren und rückkoppeln. Daher wird eine herkömmliche SQUID-FLL mit einer Stufenschaltung, welche aus mindestens einem Vorverstärker und einem Integrator besteht, in Verbindung mit einem Rückkopplungswiderstand und einer Rückkopplungsspule aufgebaut. Bei einer Umsetzung in der Praxis bestehen in einer herkömmlichen SQUID-FLL mit einem Integrator jedoch einige folgende Probleme:
1) Die Bandbreite wird begrenzt: wenn in der Ausleseschaltung mit einem Integrator mindestens zwei stufige Verstärkungsschaltungen eingesetzt werden, wird die Verzögerungszeit eines Signals der Schleife verlängert, so dass bei der Übertragung eines Hochfrequenzsignals eine Phasenverschiebung auftretet, was zu einer Schwingung der Schleife führen kann [D.Drung and M.Mück, The SQUID Handbook, vo1. I, J. Clarke and A. I. Braginski, Ed. Weinheim: Wiley-VCH, pp.128-155, 2006.] . Daher soll die Integrationskapazität erhöht werden, um die Schwingung zu eliminieren, so dass die Flux-Locked-Loop stabil bleibt. Die Erhöhung der Integrationskapazität hat jedoch zur Folge, dass die Bandbreite der Flux-Locked-Loop verringert wird.
2) Die Schwingungsfrequenz wird begrenzt: die Ausgangsgröße der integralen Schaltung ist eine Folge davon, dass das Eingangssignal der integralen Schaltung sich über Zeit integriert. Wenn das ermittelte Signal mutiert, kann der Integrator darauf nicht schnell reagieren, wird die Schwingungsfrequenz der Ausgangsspannung des Sensors somit begrenzt. Dies führt dazu, dass die Anforderungen an die Ermittlung eines Magnetfelds mit einer hohen Schwingungsfrequenz schwer zu erfüllen sind.
3) Dafür werden mindestens zwei Operationsverstärker und äußere Beschaltungen eingesetzt. Der gesamte elektrische Kreis ist komplex und hat daher eine hohe Verlustleistung zu verbrauchen.

Die Signalreaktion des SQUID-Bauelements ist von DC bis GHz und durch ihre hohe Geschwindigkeit und hohe Bandbreite charakterisiert. Wegen der vorstehenden Ausleseschaltung mit einem Integrator wird die Leistung eines SQUID-Magnetsensors in Bezug auf die Reaktionsbandbreite und die Schwingungsfrequenz beschränkt. Darüber hinaus hat ein SQUID-Chip mit der Mikroelektroniktechnik einzigartige Vorteile, zum Beispiel kleine Größe und hohen Integrationsgrad. Er wird daher in vielen mehrkanaligen Ermittlungssystemen mit hoher Auflösung, wie zum Beispiel einem 64-kanäligen MKG-Gerät oder einem 200-kanäligen MEG-Gerät unter Verwendung von SQUID, weit eingesetzt. Ein mehrkanaliges System erstellt jedoch eine höhere Anforderung an der Miniaturisierung eines SQUID-Sensors. Deshalb ist die Vereinfachung einer SQUID-Ausleseschaltung für eine mehrkanalige SQUID-Anwendung von großer und praktischer Bedeutung. Die vorliegende Erfindung strebt nach kreativen Lösungen für die o.g. Probleme.

Aus den Druckschriften DE 10 2013 016739 A1, HP H07 98370 A, CN 203 720 338 U, EP 2 476 005 A1 sowie JP H07 5233 A lässt sich ein SQUID-Magnetfeldsensor mit den Merkmalen des Oberbegriffs herleiten.

Die Aufgabe der vorliegenden Erfindung besteht darin, ein SQUID-Sensor mit einem einzelnen Operationsverstärker zu erzielen. Zur Lösung der Aufgabe umfasst ein SQUID-Magnetfeldsensor die Merkmale des Anspruchs 1. Die vorliegende Erfindung stellt für ein mehrkanaliges hoch integriertes SQUID-System eine konstruktiv vereinfachte Ausleseschaltung bereit, mit der ein SQUID-Sensor aufgebaut wird.

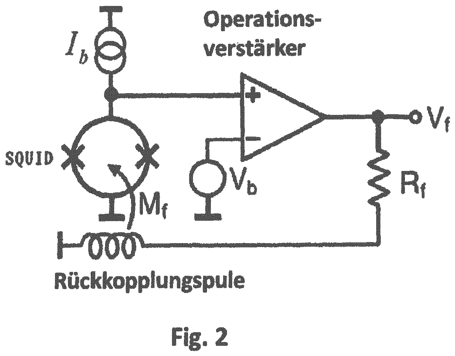

Ein SQUID besitzt eine höhere Reaktionsgeschwindigkeit als ein Halbleiterverstärker und durch ein SQUID und einen Verstärker kann eine stabile negative Rückkopplungsschleife erzielt werden. Die vorliegenden Erfindung ist darauf gerichtet, dass nur ein einzelner rauscharmer Operationsverstärker verwendet wird, um auf die Weise von "open loop" ein Spannungssignal des SQUID zu verstärken, und dass ein Rückkopplungswiderstand und eine Rückkopplungsspule durch eine Ausgangsgröße, die der einzelnen Operationsverstärker auf die Weise von "open loop" ausgibt, unmittelbar betrieben werden, statt eines Vorverstärkers und eines Integrators in einer herkömmlichen Flux-Locked-Loop. Dadurch ergibt sich ein konstruktiv einfacher Aufbau der SQUID-FLL. Für eine SQUID-FLL mit einem einzelnen Operationsverstärker gibt es zwei folgende Verbindungsarte:
1) Die Verbindung mit dem positiven Eingangsanschluss ist wie in Fig.2 dargestellt. Der von einer Biasstromquelle angeboten Biasstrom I_{b} wird in das SQUID eingebracht und das Spannungssignal des SQUID wird an den positiven Eingangsanschluss des Operationsverstärkers angelegt. Die Biasspannung V_{b} wird an den negativen Eingangsanschluss des Operationsverstärkers angelegt. Der Ausgangsanschluss des Operationsverstärkers wird mit einem Ende des Rückkopplungswiderstands R_{f} verbunden und das andere Ende des Rückkopplungswiderstands wird mit der Rückkopplungsspule verbunden, die mit dem SQUID durch eine Gegeninduktion gekoppelt ist. Dadurch, dass die Ausgangsspannung des Operationsverstärkers den Rückkopplungswiderstand R_{f} betreibt, wird ein Strom erzeugt. Durch die Gegeninduktion M_{f} zwischen der Rückkopplungsspule und dem SQUID wird ein Rückkopplungsmagnetfluss erzeugt. Die Flux-Locked-Loop ist somit ausgebildet.

Für die o.g. Verbindung mit dem positiven Eingangsanschluss ist eine von drei Ausführungsformen 1, 3 und 5 (nämlich A, B und C) zu wählen (siehe die folgenden Ausführungsbeispiele).

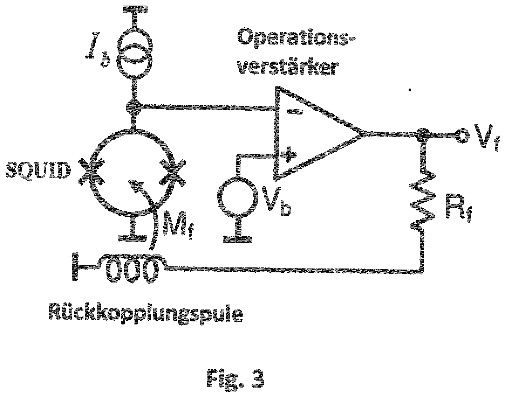

2) Die Verbindung mit dem negativen Eingangsanschluss ist wie in Fig.3 dargestellt. Der von einer Biasstromquelle angeboten Biasstrom I_{b} wird in das SQUID eingebracht und das Spannungssignal des SQUID wird an den negativen Eingangsanschluss des Operationsverstärkers angelegt. Die Biasspannung V_{b} wird an den positiven Eingangsanschluss des Operationsverstärkers angelegt. Der Ausgangsanschluss des Operationsverstärkers wird mit einem Ende des Rückkopplungswiderstands R_{f} verbunden und das andere Ende des Rückkopplungswiderstands wird mit der Rückkopplungsspule verbunden, die mit dem SQUID durch eine Gegeninduktion gekoppelt ist. Dadurch, dass die Ausgangsspannung des Operationsverstärkers den Rückkopplungswiderstand R_{f} betreibt, wird ein Strom erzeugt. Durch die Gegeninduktion M_{f} zwischen der Rückkopplungsspule und dem SQUID wird ein Rückkopplungsmagnetfluss erzeugt. Die Flux-Locked-Loop ist somit ausgebildet.

Für die o.g. Verbindung mit dem negativen Eingangsanschluss ist eine von drei Ausführungsformen 2, 4 und 6 (nämlich D, E und F) zu wählen (siehe die folgenden Ausführungsbeispiele).

In der vorliegenden Erfindung wird eine SQUID-FLL nur mit einem einzelnen Operationsverstärker ausgebildet und hat sie daher eine einfache Konstruktion. Durch den Verzicht auf den Einsatz eines Integrators in einer herkömmlichen Schleife wird die Verzögerungszeit der Schleife verkürzt, so dass die Flux-Locked-Loop eine höhere Bandbreite besitzen kann. Dadurch, dass die Ausgangsgröße des Operationsverstärkers den Rückkopplungswiderstand und die Rückkopplungsspule direkt betreibt, wird der Einfluss der Integrationskapazität vermieden, so dass die Flux-Locked-Loop eine höhere Schwingungsfrequenz besitzen kann. Darüber hinaus, der vorstehende elektrische Kreis wird mit einem einzelnen Operationsverstärker und wenigen äußeren Beschaltungen aufgebaut und hat daher kleine Größe und wenige Verlustleistung zu verbrauchen. Die von mehrkanaligen SQUID-Sensoren integrierte gesamte Größe und Verlustleistung wird erheblich verringert, was für eine mehrkanalige SQUID-Anwendung von großer Bedeutung ist.
Fig. 1 zeigt die Funktionsweise einer typischen Ausleseschaltung für direkte Auslesung;
Fig. 2 zeigt die Funktionsweise einer SQUID-FLL mit einem einzelnen Operationsverstärker, wobei die Spannung am positiven Eingangsanschluss angelegt wird;
Fig. 3 zeigt die Funktionsweise einer SQUID-FLL mit einem einzelnen Operationsverstärker, wobei die Spannung am negativen Eingangsanschluss angelegt wird;
Fig. 4 zeigt den Fall einer SQUID-FLL mit einem einzelnen Operationsverstärker, wobei B1 eine Biasstromregelschaltung und B2 eine Biasspannungsregelschaltung ist;
Fig. 5 zeigt den Fall einer SQUID-FLL mit einem einzelnen Operationsverstärker;
Fig. 6 zeigt den Fall einer SQUID-FLL mit einem einzelnen Operationsverstärker;
Fig. 7 zeigt den Fall einer SQUID-FLL mit einem einzelnen Operationsverstärker;
Fig. 8 zeigt ein Ausführungsbeispiel einer SQUID-FLL mit einem einzelnen Operationsverstärker;
Fig. 9 zeigt ein weiteres Ausführungsbeispiel einer SQUID-FLL mit einem einzelnen Operationsverstärker.

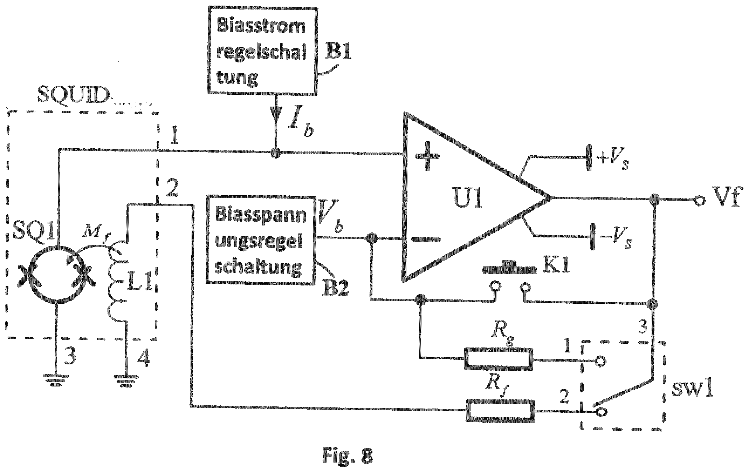

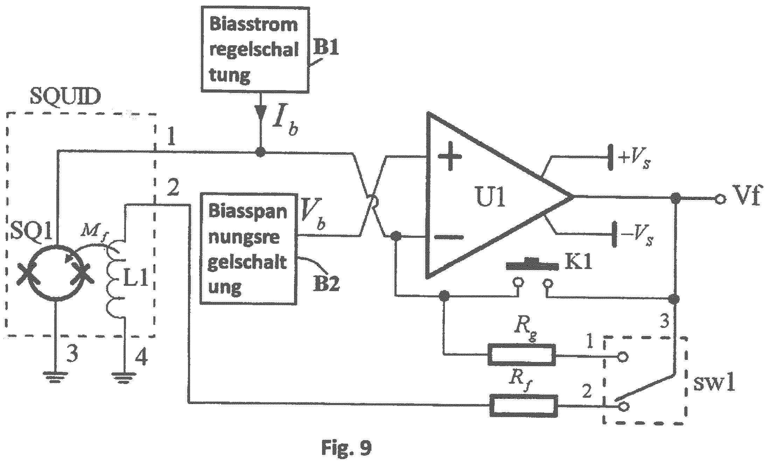

Die vorliegende Erfindung hat zwei Ausführungsbeispiele, nämlich die in den Figuren 8 und 9 gezeigten Beispiele:

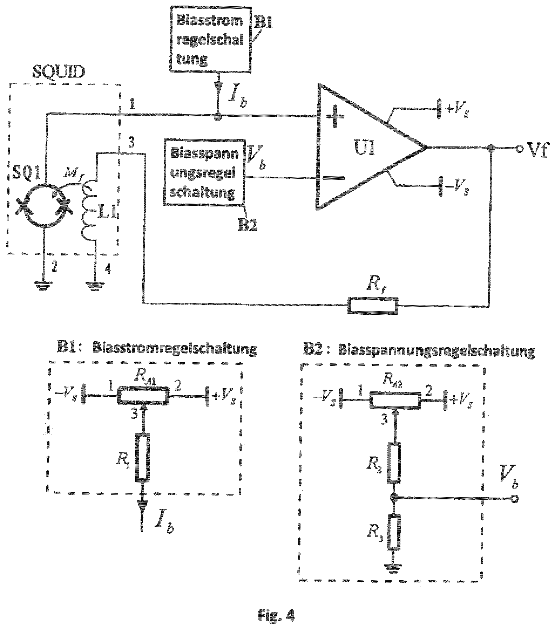

1) Die Fig. 4 zeigt die Verbindungsart A mit dem positiven Eingangsanschluss.
   1. Die Versorgungsquellen +Vs und -Vs: für die Versorgung des gesamten elektrischen Kreises wird hier eine bipolare Spannungsversorgung eingesetzt, nämlich wird am positiven Anschluss +Vs eine positive Spannungsquelle eingeschaltet und wird am negativen Anschluss -Vs eine negative Spannungsquelle eingeschaltet. Die positive Spannungsquelle +Vs beträgt im Bereich von +5V bis +15V, während die entsprechende negative Spannungsquelle -Vs im Bereich von -5V bis -15V beträgt.
   2. Die SQUID-Biasstromregelschaltung B1: sie dient dazu, in das SQUID einen zu zwei Josephson-Kontakten des SQUID zufließenden Biasstrom einzubringen, welcher einstellbar ist. Durch die Einstellung des in das SQUID eingebrachten Biasstroms kann das SQUID die beste Magnetfluss-Spannung-Umwandlungseigenschaft besitzen. Eine Ausführungsform der Biasstromregelschaltung ist wie in Fig. 3 der Modul B1 dargestellt: bei dem einstellbaren Potentiometer R_{A1} handelt es sich um ein verstellbares Widerstandbauelement mit drei Enden, wobei die Größe des Widerstands zwischen den Enden 1 und 2 des Potentiometers festliegt und vorzugsweise zwischen 10K Ohm und 100K Ohm beträgt, und das Ende 3 des Potentiometers ein verschiebbarer Kontaktanschluss auf dem verstellbaren Widerstandbauelement ist. Die Enden 1 und 2 des Potentiometers R_{A1} wird jeweils mit der positiven Spannungsquelle +Vs und der negative Spannungsquelle -Vs eingeschaltet. Am Ende 3 des Potentiometers R_{A1} wird eine Teilspannung über einen Widerstand im Potentiometer ausgegeben. Durch die Änderung der Lage des verschiebbaren Kontaktanschlusses des Potentiometers ist diese Spannung einstellbar. Der Ausgangsanschluss, an dem diese Spannung ausgegeben wird, wird mit einem Ende des Widerstands R₁ geschaltet und das andere Ende des Widerstands R₁, welches auch als der Ausgangsanschluss der Biasstromquelle dient, wird mit dem SQUID in Serie geschaltet. Der Widerstand R₁ beträgt zwischen 50K Ohm und 200K Ohm. Durch die Einstellung des verstellbaren Potentiometers R_{A1} kann ein Biasgleichstrom erzeugt werden, welcher im Bereich von -100uA bis +100uA beträgt.
   3. Die SQUID-Biasspannungsregelschaltung B2: sie dient dazu, eine einstellbare Spannung zu erzeugen, der auf den negativen Anschluss des Operationsverstärkers aufgebracht wird. Durch die Einstellung wird es ermöglicht, dass diese Spannung gleich der Gleichspannung im Arbeitspunkt des SQUID ist, so dass im Arbeitspunkt auf Null gesetzt wird. Eine Ausführungsform der Biasspannunsregelschaltung ist wie in Fig. 3 das Modul B2 dargestellt: bei dem einstellbaren Potentiometer R_{A2} handelt es sich um ein verstellbares Widerstandbauelement mit drei Enden, wobei die Größe des Widerstands zwischen den Enden 1 und 2 des Potentiometers festliegt und vorzugsweise zwischen 10K Ohm und 100K Ohm beträgt. Die Enden 1 und 2 des Potentiometers R_{A2} wird jeweils mit der positiven Spannungsquelle +Vs und der negative Spannungsquelle -Vs eingeschaltet. Am Ende 3 des Potentiometers R_{A2} wird eine Teilspannung über einen Widerstand im Potentiometer ausgegeben. Der Ausgangsanschluss, an dem die Teilspannung ausgegeben wird, wird mit einem Ende des Widerstands R₃ geschaltet und das andere Ende des Widerstands R₃ wird mit einem Ende des Widerstands R₂ in Serie geschaltet, das andere Ende des Widerstands R₂ wird zur Masse geschaltet. An einer Verbindungsstelle zwischen dem Widerstand R₂ und dem Widerstand R₃ wird die über den Widerstand gefallene Teilspannung ausgeführt, als das Biasspannungssignal V_{b}. Die Biasspannung kann von -100uV bis +100uV eingestellt werden. Der Widerstand R₃ beträgt in der Regel zwischen 1 Ohm und 10 Ohm, damit das durch ihn am Eingangsanschluss des Operationsverstärkers eingeführte thermische Rauschen unterdrückt wird. Der Widerstand R₂ beträgt zwischen 10K Ohm und 100K Ohm.
   4. Das SQUID-Bauelement SQ1: für SQ1 kann ein für niedrige Temperatur geeigneter DC-SQUID, der bei der Temperatur des flüssigen Ammoniaks von 4.2K arbeitet, oder ein für hohe Temperatur geeigneter DC-SQUID, der bei der Temperatur des flüssigen Ammoniaks von 77K arbeitet, eingesetzt werden. SQ1 ist ein Bauelement mit zwei Anschlüssen. Ein Anschluss des SQ1 wird mit dem positiven Eingangsanschluss des Operationsverstärkers verbunden und zugleich mit dem Stromausgangsanschluss der Biasstromregelschaltung B1 verbunden. Der andere Anschluss des SQ1 wird zur Masse verbunden.
   5. Die Rückkopplungsspule L1: sie ist eine mit dem SQUID induktiv gekoppelte Spule, wobei die Gegeninduktivität mit M_{f} bezeichnet wird. Durch die Rückkopplungsspule wird der in der Rückkopplungsschaltung erzeugten Storm in den Rückkopplungsmagnetfluss umgewandelt, der in das SQUID gekoppelt wird. Ein Magnetfluss zur Aufhebung wird somit ausgebildet. Ein Ende der Rückkopplungsspule L1 wird mit dem Widerstand R_{f} verbunden und das andere Ende der Rückkopplungsspule L1 wird zur Masse verbunden.
   6. Der Operationsverstärker U1: ein bipolar betriebener rauscharmer Operationsverstärker hat zwei Eingänge für Spannungssignale, nämlich einen positiven Eingang und einen negativen Eingang, sowie einen Ausgang für die verstärkten Spannungssignale. In den Figuren, am positiven Eingang des Operationsverstärkers wird die Spannungsausgabe des SQUID angelegt und am negativen Eingang des Operationsverstärkers wird die Biasspannungsausgabe angelegt. Der Ausgang des Operationsverstärkers dient auch als der Ausgang der Flux-Locked-Loop und des gesamten Sensors und wird zugleich mit dem Rückkopplungswiderstand R_{f} verbunden. Um ein Spannungssignal des SQUID rauscharm zu verstärken und eine hoch lineare Ausgabe der Flux-Locked-Loop zu erhalten, ist für den erfindungsgemäßen Operationsverstärker ein Bauelemente mit kleinen eingegeben Spannungsrauschen und mit der Charakteristik von hoher Bandbreite und hoher Leerlaufverstärkung bevorzugt: die Spannungsrauschen des Operationsverstärker betragen ca. 1nV/VHz, die Leerlaufverstärkung ist größer als 120dB, die Verstärkung-Bandbreiteprodukt ist größer als 10MHz. Für einen rauscharmen Operationsverstärker steht AD797 von der amerikanischen Firma ADI oder LT1028 von der Firma Linear Technology häufig zur Verfügung.
   7. Der Rückkopplungswiderstand R_{f}: ein Ende des Rückkopplungswiderstands R_{f} wird mit dem Ausgangsanschluss des Operationsverstärkers U1 verbunden und das andere Ende wird mit der Rückkopplungsspule L1 verbunden. Durch den Rückkopplungswiderstand R_{f} wird die Ausgangsspannung des Operationsverstärkers in einen Rückkopplungsstrom umgewandelt, der in die Rückkopplungsspule eingeführt wird. Ein Rückkopplungsmagnetfluss wird somit erzeugt. Der Widerstand R_{f} beträgt zwischen 100 Ohm und 10K Ohm.

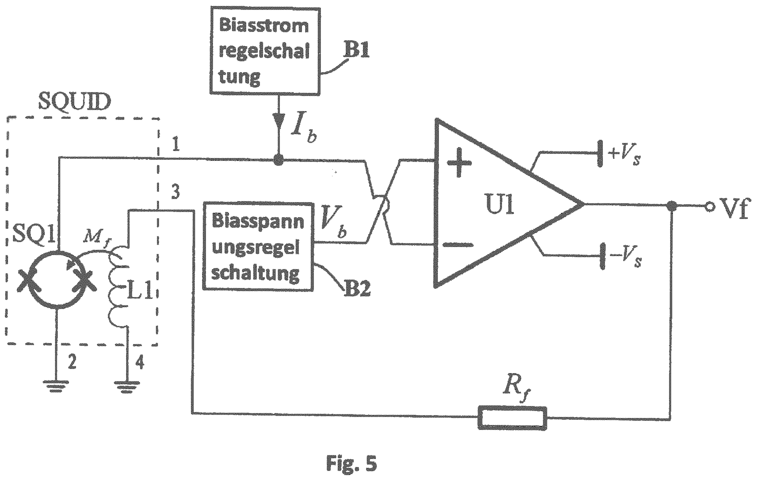

2) In Fig. 5 wird die Verbindungsart D mit dem positiven Eingangsanschluss dargestellt.

Abweichend von dem in der Figur 4 gezeigten Fall, werden die Spannungssignale des SQUID am negativen Eingang des Operationsverstärkers U1 und die Biasspannungssignale werden am positiven Eingang des Operationsverstärkers angelegt. Darüber hinaus wird wie in Figur 4 gezeigt verbunden.

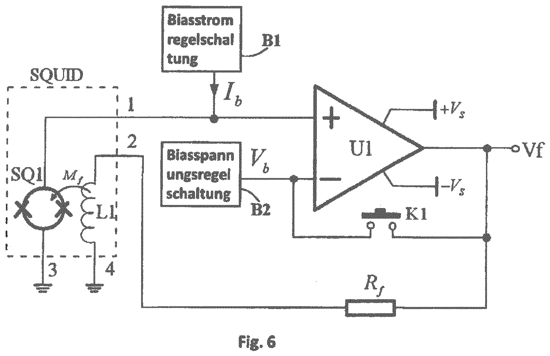

3) In Fig. 6 ist die Verbindungsart B mit dem positiven Eingangsanschluss dargestellt.

Unter äußeren Störungen kann es zu einer Entriegelung der Flux-Locked-Loop kommen, was zum Ausgabenüberlauf führt. Aber mit einem Rücksetzschalter kann die Verriegelung der Flux-Locked-Loop wiederhergestellt werden. Auf der Grundlage des in der Figur 4 gezeigten Falls wird ein Rücksetzschalter K1 hinzugefügt, um die Rücksetzfunktion zu erzielen. Ein Ende des Rücksetzschalters K1 wird mit dem negativen Eingangsanschluss des Operationsverstärkers U1 verbunden, das andere Ende des Rücksetzschalters K1 wird mit dem Ausgangsanschluss des Operationsverstärkers U1 verbunden. Wenn der Rücksetzschalter geschlossen wird, ist das elektrische Potential am Ausgangsanschluss des Operationsverstärkers U1 gleich dem elektrischen Potential am negativen Eingangsanschluss. In diesem Fall verändert sich der Operationsverstärker von der hohen Leerlaufverstärkung zu der Verstärkung eines Verstärkungsfaktors (Unity Gain in Englisch), und die Ausgabe verringert sich schnell. Der elektrische Kreis wird somit zurückgesetzt. Der elektrische Kreis ist aber wieder verriegelt, wenn der Rücksetzschalter K1 geöffnet wird.

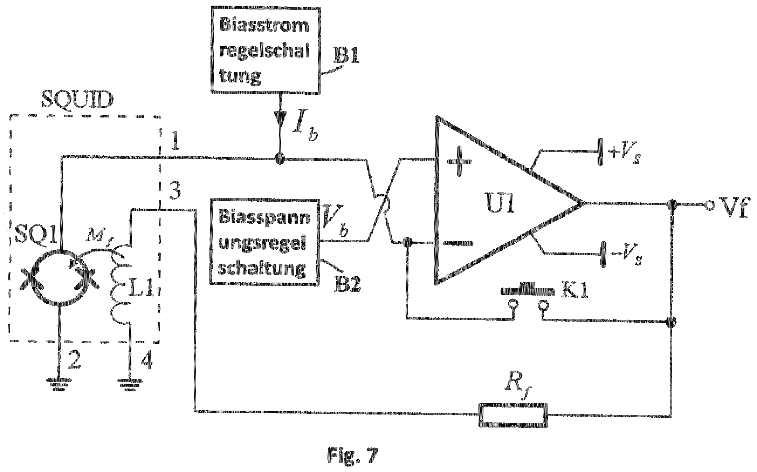

4) In Fig. 7 ist die Verbindungsart E mit dem positiven Eingangsanschluss dargestellt.

Abweichend von dem in der Figur 6 gezeigten Fall werden die Spannungssignale des SQUID am negativen Eingang des Operationsverstärkers U1 und die Biasspannungssignale werden am positiven Eingang des Operationsverstärkers angelegt. Im Übrigen wird wie in Figur 6 gezeigt verbunden.

5) Ein Ausführungsbeispiel ist wie in Fig. 8 dargestellt, nämlich die Verbindungsart C mit dem positiven Eingangsanschluss.

Wenn der SQUID-Sensor elektrisch eingeschaltet ist, sollen der Biasstrom und die Biasspannung erneut eingestellt werden, damit das SQUID im besten Arbeitspunkt arbeiten kann. Im Ausführungsbeispiel, auf der Grundlage des in der Figur 6 gezeigten Falls werden ein Rückkopplungswiderstand R_{g} und ein einpoliger Wechselschalter SW1 (Single Pole Double Throw in Englisch) hinzugefügt, so dass die Flux-Locked-Loop die Arbeitspunkteinstellungsfunktion erzielen kann. Der einpolige Wechselschalter weist drei Enden für Verbindungen auf, wobei das Ende 3 als der feste einpolige Verbindungsanschluss definiert ist, das Ende 1 als der erste Kontaktanschluss und das Ende 2 als der zweite Kontaktanschluss definiert sind. Der feste einpolige Verbindungsanschluss des SW1 wird mit dem Ausgangsanschluss des Operationsverstärkers U1 verbunden. Der Verbindungsanschluss am Ende 1 des SW1 wird mit einem Ende des Widerstands R_{g} verbunden, das andere Ende des R_{g} wird mit dem negativen Eingangsanschluss des Operationsverstärkers U1 verbunden. Der Verbindungsanschluss am Ende 2 des SW1 wird mit einem Ende des Rückkopplungswiderstand R_{f} verbunden, das andere Ende des Rückkopplungswiderstand R_{f} wird mit der Rückkopplungsspule L1 verbunden. Wenn der einpolige Wechselschalter SW1 mit dem zweiten Kontaktanschluss abgetrennt und mit dem ersten Kontaktanschluss eingeschaltet ist, kommt der Widerstand R_{g} mit dem Ausgangsanschluss des Operationsverstärkers U1 zur Verbindung. In diesem Fall befinden sich die Flux-Locked-Loop im Leerlauf und der Operationsverstärker im Betriebsmodus der proportionalen Verstärkung. Die Spannungssignale des SQUID werden somit proportional verstärkt. Durch die Ermittlung der Ausgangspannung V_{f} des Operationsverstärkers kann eine Fluss-Spannung-Übertragungskennlinie erhalten werden. Mit ihrer Hilfe können der Arbeitspunkt des SQUID und der Biasstrom und die Biasspannung eingestellt werden. Nachdem der Biasstrom und die Biasspannung auf die besten Werte eingestellt sind, wird der einpolige Wechselschalter SW1 mit dem ersten Kontaktanschluss abgetrennt und mit dem zweiten Kontaktanschluss eingeschaltet, so dass der Ausgangsanschluss des Operationsverstärkers U1 mit dem Rückkopplungswiderstand R_{f} verbunden wird. In diesem Fall wird die Flux-Locked-Loop ihre Ausgabe auf die Weise von "close loop" verriegelt.

6) Ein weiteres Ausführungsbeispiel ist wie in Fig. 9 dargestellt, nämlich die Verbindungsart F mit dem positiven Eingangsanschluss.

Abweichend vom vorhergehenden Ausführungsbeispiel werden die Spannungssignale des SQUID am negativen Eingang des Operationsverstärkers U1 und die Biasspannungssignale werden am positiven Eingang des Operationsverstärkers angelegt. Im Übrigen wird wie im vorhergehenden Ausführungsbeispiel verbunden.

## Patentansprüche

1. SQUID-Magnetfeldsensor mit nur einem einzelnen rauscharmen Operationsverstärker, , um auf die Weise von Open-Loop ein Spannungssignal des SQUID zu verstärken, wobei der Magnetfeldsensor so eingerichtet ist, dass ein Rückkopplungswiderstand und eine Rückkopplungsspule durch eine Ausgangsgröße, die der einzelnen Operationsverstärker auf die Weise von Open-Loop ausgibt, unmittelbar betrieben werden, **dadurch gekennzeichnet, dass** ein weiterer Rückkopplungswiderstand (R_{g}) und ein einpoliger Wechselschalter (SW1) vorhanden sind, wobei der feste, einpolige Verbindungsanschluss des Wechselschalters (SW1) mit dem Ausgangsanschluss des Operationsverstärkers (U1) verbunden ist, wobei ein erster Verbindungsanschluss des Wechselschalters (SW1) mit einem Ende des weiteren Rückkopplungswiderstands (R_{g}) verbunden ist, wobei ein zweiter Verbindungsanschluss des Wechselschalters (SW1) mit einem Ende des Rückkopplungswiderstands verbunden ist, dessen anderes Ende mit der Rückkopplungsspule (L1) verbunden ist, wobei das andere Ende des weiteren Rückkopplungswiderstands (R_{g}) mit dem negativen Eingangsanschluss des Operationsverstärkers (U1) verbunden ist.

2. SQUID-Magnetfeldsensor nach Anspruch 1, **dadurch gekennzeichnet, dass** kein Integrator für ein Integrieren von Ausgangssignalen eines Vorverstärkers vorhanden ist.

3. SQUID-Magnetfeldsensor nach Anspruch 1 oder 2, **dadurch gekennzeichnet, dass** der Operationsverstärker ein bipolar betriebener, rauscharmer Operationsverstärker mit zwei Eingängen für Spannungssignale ist und zwar einem positiven Eingang und einem negativen Eingang und der Operationsverstärker einen Ausgang für verstärkte Spannungssignale aufweist.

4. SQUID-Magnetfeldsensor nach dem vorhergehenden Anspruch, **dadurch gekennzeichnet, dass** an einem Eingang des Operationsverstärkers die Spannungsausgabe des SQUIDs angelegt ist und am anderen Eingang des Operationsverstärkers eine Biasspannungsausgabe angelegt ist.

5. SQUID-Magnetfeldsensor nach einem der vorhergehenden Ansprüche, **dadurch gekennzeichnet, dass** ein Ende des Rückkopplungswiderstands (R_{f}) mit dem Ausgang des Operationsverstärkers und das andere Ende des Rückkopplungswiderstands (R_{f}) mit der Rückkopplungsspule (L1) verbunden ist.

6. SQUID-Magnetfeldsensor nach einem der vorhergehenden Ansprüche, **dadurch gekennzeichnet, dass** eine SQUID-Biasstromregelschaltung (B1) vorhanden ist, mit der in das SQUID ein zu zwei Josephson-Kontakten zufließender Biasstrom eingebracht werden kann, wobei der Bias-Strom einstellbar ist.

7. SQUID-Magnetfeldsensor nach einem der vorhergehenden Ansprüche, **dadurch gekennzeichnet, dass** ein Rücksetzschalter (K1) vorhanden ist, wobei ein Ende des Rücksetzschalters mit dem negativen Eingangsanschluss des Operationsverstärkers verbunden ist und das andere Ende des Rücksetzschalters mit dem Ausgangsanschluss des Operationsverstärkers verbunden ist.

8. SQUID-Magnetfeldsensor nach Anspruch 1, ***dadurch gekennzeichnet, dass*** der Magnetfeldsensor so eingerichtet ist, dass die SQUID-FLL mit dem einzelnen Operationsverstärker zwei folgenden Verbindungsarten hat:
1) die Verbindungsart mit dem positiven Eingangsanschluss: ein von einer Biasstromquelle angeboten Biasstrom I_{b} wird in das SQUID eingebracht und ein Spannungssignal des SQUID wird an den positiven Eingangsanschluss des Operationsverstärkers angelegt; die Biasspannung V_{b} wird an den negativen Eingangsanschluss des Operationsverstärkers angelegt, der Ausgangsanschluss des Operationsverstärkers wird mit einem Ende des Rückkopplungswiderstands R_{f} verbunden und das andere Ende des Rückkopplungswiderstands wird mit der Rückkopplungsspule verbunden, die mit dem SQUID durch eine Gegeninduktion gekoppelt ist, und ein Strom wird dadurch, dass die Ausgangsspannung des Operationsverstärkers den Rückkopplungswiderstand R_{f} betreibt, erzeugt, ein Rückkopplungsmagnetfluss wird durch die Gegeninduktion M_{f} zwischen der Rückkopplungsspule und dem SQUID erzeugt, die Flux-Locked-Loop wird somit ausgebildet;
2) die Verbindungsart mit dem negativen Eingangsanschluss: ein von einer Biasstromquelle angeboten Biasstrom I_{b} wird in das SQUID eingebracht und ein Spannungssignal des SQUID wird an den negativen Eingangsanschluss des Operationsverstärkers angelegt, die Biasspannung V_{b} wird an den positiven Eingangsanschluss des Operationsverstärkers angelegt, der Ausgangsanschluss des Operationsverstärkers wird mit einem Ende des Rückkopplungswiderstands R_{f} verbunden und das andere Ende des Rückkopplungswiderstands wird mit der Rückkopplungsspule verbunden, die mit dem SQUID durch eine Gegeninduktion gekoppelt ist, ein Strom wird dadurch, dass die Ausgangsspannung des Operationsverstärkers den Rückkopplungswiderstand R_{f} betreibt, erzeugt, ein Rückkopplungsmagnetfluss wird durch die Gegeninduktion M_{f} zwischen der Rückkopplungsspule und dem SQUID erzeugt, die Flux-Locked-Loop wird somit ausgebildet.

9. SQUID-Magnetfeldsensor nach Anspruch 8, ***dadurch gekennzeichnet:***
***1) dass*** der Magnetfeldsensor so eingerichtet ist, dass für die Verbindungsarten mit dem positiven Eingangsanschluss eine von drei folgenden Formen A, B und C zu wählen ist:
A:
□ die Versorgungsquellen +Vs und -Vs: für die Versorgung des gesamten elektrischen Kreises wird eine bipolare Spannungsversorgung eingesetzt, nämlich wird am positiven Anschluss +Vs eine positive Spannungsquelle eingeschaltet und wird am negativen Anschluss -Vs eine negative Spannungsquelle eingeschaltet;
□ die SQUID-Biasstromregelschaltung B1: sie dient dazu, in das SQUID einen zu zwei Josephson-Kontakten des SQUID zufließenden Biasstrom einzubringen, durch die Einstellung des in das SQUID eingebrachten Biasstroms besitzt das SQUID die beste Magnetfluss-Spannung-Umwandlungseigenschaft; in der Biasstromregelschaltung handelt es sich bei dem einstellbaren Potentiometer R_{A1} um ein verstellbares Widerstandbauelement mit drei Enden, wobei die Größe des Widerstands zwischen den Enden 1 und 2 des Potentiometers festliegt und das Ende 3 des Potentiometers ein verschiebbarer Kontaktanschluss auf dem verstellbaren Widerstandbauelement ist, die Enden 1 und 2 des Potentiometers R_{A1} werden jeweils mit der positiven Spannungsquelle +Vs und der negative Spannungsquelle -Vs eingeschaltet; am Ende 3 des Potentiometers R_{A1} wird eine Teilspannung über einen Widerstand im Potentiometer ausgegeben, durch die Änderung der Lage des verschiebbaren Kontaktanschlusses des Potentiometers ist diese Spannung einstellbar; der Ausgangsanschluss für die Ausgabe dieser Spannung wird mit einem Ende des Widerstands R₁ geschaltet und das andere Ende des Widerstands R₁ wird mit dem SQUID in Serie geschaltet;
□ die SQUID-Biasspannungsregelschaltung B2: sie dient dazu, eine einstellbare Spannung zu erzeugen, der auf den negativen Anschluss des Operationsverstärkers aufgebracht wird, durch die Einstellung wird diese Spannung gleich der Gleichspannung im Arbeitspunkt des SQUID, so dass im Arbeitspunkt auf Null gesetzt wird, in der Biasspannungsregelschaltung handelt es sich bei dem einstellbaren Potentiometer R_{A2} um ein verstellbares Widerstandbauelement mit drei Enden, wobei die Größe des Widerstands zwischen den Enden 1 und 2 des Potentiometers festliegt und vorzugsweise zwischen 10K Ohm und 100K Ohm beträgt, die Enden 1 und 2 des Potentiometers R_{A2} wird jeweils mit der positiven Spannungsquelle +Vs und der negative Spannungsquelle -Vs eingeschaltet, am Ende 3 des Potentiometers R_{A2} wird eine Teilspannung über einen Widerstand im Potentiometer ausgegeben, der Ausgangsanschluss für die Ausgabe dieser Teilspannung wird mit einem Ende des Widerstands R₃ geschaltet und das andere Ende des Widerstands R₃ wird mit einem Ende des Widerstands R₂ in Serie geschaltet, das andere Ende des Widerstands R₂ wird zur Masse geschaltet; an einer Verbindungsstelle zwischen dem Widerstand R₂ und dem Widerstand R₃ wird die über den Widerstand gefallene Teilspannung ausgeführt, als das Biasspannungssignal V_{b};
□ das SQUID-Bauelement SQ1: für SQ1 kann ein für niedrige Temperatur geeigneter DC-SQUID, der bei der Temperatur des flüssigen Ammoniaks von 4.2K arbeitet, oder ein für hohe Temperatur geeigneter DC-SQUID, der bei der Temperatur des flüssigen Ammoniaks von 77K arbeitet, eingesetzt werden, SQ1 ist ein Bauelement mit zwei Anschlüssen, ein Anschluss des SQ1 wird mit dem positiven Eingangsanschluss des Operationsverstärkers verbunden und zugleich mit dem Stromausgangsanschluss der Biasstromregelschaltung B1 verbunden, der andere Anschluss des SQ1 wird zur Masse verbunden;
□ die Rückkopplungsspule L1: sie ist eine mit dem SQUID induktiv gekoppelte Spule, durch die Rückkopplungsspule wird der in der Rückkopplungsschaltung erzeugten Storm in den Rückkopplungsmagnetfluss umgewandelt, der in das SQUID gekoppelt wird, ein Magnetfluss zur Aufhebung wird somit ausgebildet; ein Ende der Rückkopplungsspule L1 wird mit dem Widerstand R_{f} verbunden und das andere Ende der Rückkopplungsspule L1 wird zur Masse verbunden;
□ der Operationsverstärker U1: ein bipolar betriebener rauscharmer Operationsverstärker hat zwei Eingänge für Spannungsignale, nämlich einen positiven Eingangsanschluss und einen negativen Eingangsanschluss, sowie einen Ausgangsanschluss für die verstärkten Spannungssignale; am positiven Eingangsanschluss des Operationsverstärkers wird die Spannungsausgabe des SQUID angelegt und am negativen Eingangsanschluss des Operationsverstärkers wird die Biasspannungsausgabe angelegt, der Ausgangsanschluss des Operationsverstärkers dient auch als der Ausgangsanschluss des gesamten Sensors und wird zugleich mit dem Rückkopplungswiderstand R_{f} verbunden;
□ der Rückkopplungswiderstands R_{f}: ein Ende des Rückkopplungswiderstands R_{f} wird mit dem Ausgangsanschluss des Operationsverstärkers U1 verbunden und das andere Ende wird mit der Rückkopplungsspule L1 verbunden; durch den Rückkopplungs- widerstand R_{f} wird die Ausgangsspannung des Operationsverstärkers in einen Rückkopplungsstrom umgewandelt, der in die Rückkopplungsspule eingeführt wird, ein Rückkopplungsmagnetfluss wird somit erzeugt;
B:
auf der Grundlage von A wird ein Rücksetzschalter K1 hingefügt, um die Rücksetzfunktion zu erzielen; ein Ende des Rücksetzschalters K1 wird mit dem negativen Eingangsanschluss des Operationsverstärkers U1 verbunden, das andere Ende des Rücksetzschalters K1 wird mit dem Ausgangsanschluss des Operationsverstärkers U1 verbunden; wenn der Rücksetzschalter geschlossen wird, ist das elektrische Potential am Ausgangsanschluss des Operationsverstärkers U1 gleich dem elektrischen Potential am negativen Eingangsanschluss, in diesem Fall, der Operationsverstärker verändert sich von der hohen Leerlaufverstärkung zu der Verstärkung eines Verstärkungsfaktors, und die Ausgabe verringert sich schnell, und der elektrische Kreis wird somit zurückgesetzt; wenn der Rücksetzschalter K1 geöffnet wird, ist der elektrische Kreis aber wieder verriegelt;
C:
auf der Grundlage von B wird ein Rückkopplungswiderstand R_{g} und ein einpoliger Wechselschalter SW1 hingefügt, so dass die Flux-Locked-Loop die Arbeitspunkteinstellungsfunktion besitzt, wobei der einpolige Wechselschalter drei Enden für Verbindung aufweist, wobei das Ende 3 als der feste einpolige Verbindungsanschluss definiert ist, das Ende 1 als der erste Kontaktanschluss und das Ende 2 als der zweite Kontaktanschluss definiert sind; der feste einpolige Verbindungsanschluss des SW1 wird mit dem Ausgangsanschluss des Operationsverstärkers U1 verbunden, ein Verbindungsanschluss am Ende 1 des SW1 wird mit einem Ende des Widerstands R_{g} verbunden, das andere Ende des R_{g} wird mit dem negativen Eingangsanschluss des Operationsverstärkers U1 verbunden, ein Verbindungsanschluss am Ende 2 des SW1 wird mit einem Ende des Rückkopplungswiderstand R_{f} verbunden, das andere Ende des Rückkopplungswiderstand R_{f} wird mit der Rückkopplungsspule L1 verbunden; wenn der einpolige Wechselschalter SW1 mit dem zweiten Kontaktanschluss abgetrennt und mit dem ersten Kontaktanschluss eingeschaltet ist, kommt der Widerstand R_{g} mit dem Ausgangsanschluss des Operationsverstärkers U1 zur Verbindung, in diesem Fall befinden sich die Flux-Locked-Loop im Leerlauf und der Operationsverstärker U1 im Betriebsmodus der proportionalen Verstärkung, die Spannungssignale des SQUID werden somit proportional verstärkt, durch die Ermittlung der Ausgangspannung V_{f} des Operationsverstärkers kann eine Fluss-Spannung-Übertragungskennlinie erhalten werden, und mit ihrer Hilfe können der Arbeitspunkt des SQUID und der Biasstrom und die Biasspannung eingestellt werden; nachdem der Biasstrom und die Biasspannung auf die besten Werte eingestellt sind, wird der einpolige Wechselschalter SW1 mit dem ersten Kontaktanschluss abgetrennt und mit dem zweiten Kontaktanschluss eingeschaltet, so dass der Ausgangsanschluss des Operationsverstärkers U1 mit dem Rückkopplungs- widerstand R_{f} verbunden wird, in diesem Fall wird die Flux-Locked-Loop ihre Ausgabe auf die Weise von "close loop" verriegelt;
***2) dass*** für die Verbindungsarte mit dem negativen Eingangsanschluss eine von drei folgenden Formen D, E und F zu wählen ist:
□ auf der Verbindungsart D wird das Spannungssignal des SQUID der Verbindungsart A am negativen Eingangsanschluss des Operationsverstärkers U1 angelegt und wird die Biasspannungssignal am positiven Eingangsanschluss des Operationsverstärkers angelegt, und werden die Übrige wie auf der Verbindungsart A verbunden;
□ auf der Verbindungsart E wird das Spannungssignal des SQUID der Verbindungsart B am negativen Eingangsanschluss des Operationsverstärkers U1 angelegt und wird die Biasspannungssignal am positiven Eingangsanschluss des Operationsverstärkers angelegt, und werden die Übrige wie auf der Verbindungsart B verbunden;
□ auf der Verbindungsart F wird das Spannungssignal des SQUID der Verbindungsart C am negativen Eingangsanschluss des Operationsverstärkers U1 angelegt und wird die Biasspannungssignal am positiven Eingangsanschluss des Operationsverstärkers angelegt, und werden die Übrige wie auf der Verbindungsart C verbunden.

10. SQUID-Magnetfeldsensor nach Anspruch 9, ***dadurch gekennzeichnet, dass*** der Magnetfeldsensor so eingerichtet ist, dass:
(1) bei einer Verbindungsart mit dem positiven oder negativen Eingangsanschluss, die positive Spannungsquelle +Vs beträgt im Bereich von +5V bis +15V und die entsprechende negative Spannungsquelle -Vs beträgt im Bereich von -5V bis -15V;
(2) in der SQUID-Biasstromregelschaltung B1, die Größe des Widerstands zwischen den Enden 1 und 2 des Potentiometers beträgt zwischen 10K Ohm und 100K Ohm; der Widerstand R₁ beträgt zwischen 50K Ohm und 200K Ohm; durch die Einstellung des verstellbaren Potentiometers R_{A1} kann ein Biasgleichstrom erzeugt werden, welcher im Bereich von 160uA beträgt;
(3) in der SQUID-Biasspannungsregelschaltung B2, das Biasspannungssignal wird von - 100uV bis +100uV eingestellt; der Widerstand R₃ beträgt zwischen 1 Ohm und 10 Ohm, der Widerstand R₂ beträgt zwischen 10K Ohm und 100K Ohm;
(4) die Spannungsrauschen des Operationsverstärker beträgen ca. 1nV/√Hz, die Leerlaufverstärkung ist größer als 120dB, die Verstärkung-Bandbreiteprodukt ist größer als 10MHz;
(5) der Rückkopplungswiderstand R_{f} beträgt zwischen 100 Ohm und 10K Ohm.

11. SQUID-Magnetfeldsensor nach Anspruch 10, ***dadurch gekennzeichnet, dass*** für den rauscharmen Operationsverstärker AD797 von der amerikanischen Firma ADI oder LT1028 von der Firma Linear Technology zu wählen.

## Claims

1. A SQUID magnetic field sensor only comprising one single low-noise operational amplifier for amplifying a voltage signal of the SQUID in the way of an open loop, wherein the magnetic field sensor is adapted such that a back coupling resistor and a back coupling coil will be directly operated by means of an output value which the single operational amplifier outputs in the way of open loop, **characterized in that** another back coupling resistor (R_{g}) and a unipolar toggle switch (SW1) are present, wherein the fixed, unipolar connection port of the toggle switch (SW1) is connected to the output terminal of the operational amplifier (U1), wherein a first connection port of the toggle switch (SW1) is connected to one end of the other back coupling resistor (R_{g}), wherein a second connection port of the toggle switch (SW1) is connected to one end of the back coupling resistor, the other end of which is connected to the back coupling coil (L1), wherein the other end of the other back coupling resistor (R_{g}) is connected to the negative input terminal of the operational amplifier (U1).

2. A SQUID magnetic field sensor according to claim 1, **characterized in that** there is no integrator for integrating output signals of a preamplifier.

3. A SQUID magnetic field sensor according to claim 1 or 2, **characterized in that** the operational amplifier is a low-noise operational amplifier operated in a bipolar manner comprising two inputs for voltage signals, namely a positive input and a negative input, and the operational amplifier comprises an output for amplified voltage signals.

4. A SQUID magnetic field sensor according to the preceding claim, **characterized in that** the voltage output of the SQUID is applied to one input of the operational amplifier and a bias voltage output is applied to the other input of the operational amplifier.

5. A SQUID magnetic field sensor according to one of the preceding claims, **characterized in that** one end of the back coupling resistor (R_{f}) is connected to the output of the operational amplifier and the other end of the back coupling resistor (R_{f}) is connected to the back coupling coil (L1).

6. A SQUID magnetic field sensor according to one of the preceding claims, **characterized in that** a SQUID bias current control circuit (B1) is given, by means of which a bias current flowing to two Josephson contacts can be introduced into the SQUID, wherein the bias current is adjustable.

7. A SQUID magnetic field sensor according to one of the preceding claims, **characterized in that** a reset switch (K1) is present, wherein one end of the reset switch is connected to the negative input terminal of the operational amplifier and the other end of the reset switch is connected to the output terminal of the operational amplifier.

8. A SQUID magnetic field sensor according to claim 1, **characterized in that** the magnetic field sensor is adapted such that the SQUID-FLL comprises two following connection types with the single operational amplifier:
1) the connection type with the positive input terminal: a bias current I_{b} provided by a bias current source is introduced into the SQUID and a voltage signal of the SQUID is applied to the positive input terminal of the operational amplifier; the bias voltage V_{b} is applied to the negative input terminal of the operational amplifier, the output terminal of the operational amplifier is connected to one end of the back coupling resistor R_{f} and the other end of the back coupling resistor is connected to the back coupling coil which is coupled to the SQUID by means of a counter-induction, and a current is generated **in that** the output voltage of the operational amplifier operates the back coupling resistor R_{f}, a back coupling magnetic flux is generated by the counter-induction M_{f} between the back coupling coil and the SQUID and thus the flux-locked-loop is formed;
2) the connection type with the negative input terminal: a bias current I_{b} provided by a bias current source is introduced into the SQUID and a voltage signal of the SQUID is applied to the negative input terminal of the operational amplifier, the bias voltage V_{b} is applied to the positive input terminal of the operational amplifier, the output terminal of the operational amplifier is connected to one end of the back coupling resistor R_{f} and the other end of the back coupling resistor is connected to the back coupling coil which is coupled to the SQUID by means of a counter-induction, a current is generated **in that** the output voltage of the operational amplifier operates the back coupling resistor R_{f}, a back coupling magnetic flux is generated by the counter-induction M_{f} between the back coupling coil and the SQUID and thus the flux-locked-loop is formed.

9. A SQUID magnetic field sensor according to claim 8, **characterized in**
**1) that** the magnetic field sensor is adapted such that one of the three following forms A, B and C has to be selected for the connection types with the positive input terminal:
A:
∘ the supply sources +Vs and -Vs: a bipolar voltage supply is used for the supply of the entire electric circuit, namely a positive voltage source is applied to the positive terminal +Vs and a negative voltage source is applied to the negative terminal -Vs;
∘ the SQUID bias current control circuit B1: it serves to introduce a bias current flowing to two Josephson contacts of the SQUID, and thanks to the adjustment of the bias current introduced into the SQUID, the SQUID has the best magnetic flux-voltage-conversion property; the adjustable potentiometer R_{A1} in the bias current control circuit is an adjustable resistor component having three ends, wherein the value of the resistor between the ends 1 and 2 of the potentiometer is fixed and the end 3 of the potentiometer is a displaceable contact connection on the adjustable resistor component, the ends 1 and 2 of the potentiometer R_{A1} are each switched on with the positive voltage source +Vs and the negative voltage source -Vs; at the end 3 of the potentiometer R_{A1} a partial voltage is output through a resistor in the potentiometer, this voltage is settable by the change of the position of the displaceable contact connection of the potentiometer; the output terminal for the output of this voltage is switched with one end of the resistor R₁ and the other end of the resistor R₁ is switched in series with the SQUID;
∘ the SQUID bias voltage control circuit B2: it serves to generate an adjustable voltage which is applied to the negative terminal of the operational amplifier, thanks to the adjustment this voltage becomes equal to the DC voltage in the operating point of the SQUID, such that it is set to zero in the operating point, the adjustable potentiometer R_{A2} in the bias voltage control circuit is an adjustable resistor component having three ends, wherein the value of the resistor between the ends 1 and 2 of the potentiometer is fixed and is preferably comprised between 10K Ohm and 100K Ohm, the ends 1 and 2 of the potentiometer R_{A2} are each switched on with the positive voltage source +Vs and the negative voltage source -Vs, at the end 3 of the potentiometer R_{A2} a partial voltage is output through a resistor in the potentiometer, the output terminal for the output of this partial voltage is switched with one end of the resistor R₃ and the other end of the resistor R₃ is switched in series with one end of the resistor R₂, the other end of the resistor R₂ is connected to ground; the partial voltage that has dropped at the resistor is output as the bias voltage signal V_{b} at a connection point between the resistor R₂ and the resistor R₃;
∘ the SQUID component SQ1: for the SQ1 it is possible to use a DC-SQUID appropriate for a low temperature, which DC-SQUID operates at the temperature of the liquid ammoniac of 4.2 K, or a DC-SQUID appropriate for a high temperature, which DC-SQUID operates at the temperature of the liquid ammoniac of 77 K; SQ1 is a component having two connections, one connection of the SQUID is connected to the positive input terminal of the operational amplifier and simultaneously to the current output terminal of the bias current control circuit B1, the other connection of the SQ1 is connected to ground,
∘ the back coupling coil L1: this is a coil which is inductively coupled to the SQUID; the current generated in the back coupling circuit is converted into the back coupling magnetic flux by means of the back coupling coil, which back coupling magnetic flux is coupled to the SQUID, a magnetic flux for cancellation is thus formed; one end of the back coupling coil L1 is connected to the resistor R_{f} and the other end of the back coupling coil L1 is connected to ground;
∘ the operational amplifier U1: a low-noise operational amplifier operated in a bipolar manner comprises two inputs for voltage signals, namely a positive input terminal and a negative input terminal, as well as an output terminal for the amplified voltage signals; the voltage output of the SQUID is applied to the positive input terminal of the operational amplifier and the bias voltage output is applied to the negative input terminal of the operational amplifier, the output terminal of the operational amplifier also serves as output terminal of the entire sensor and is simultaneously connected to the back coupling resistor R_{f};
∘ the back coupling resistor R_{f}: one end of the back coupling resistor R_{f} is connected to the output terminal of the operational amplifier U1 and the other end is connected to the back coupling coil L1; the output voltage of the operational amplifier is converted into a back coupling current by means of the back coupling resistor R_{f}, which back coupling current is introduced into the back coupling coil and thus a back coupling magnetic flux is generated;
B:
on the base of A, a reset switch K1 is added in order to obtain the reset function; one end of the reset switch K1 is connected to the negative input terminal of the operational amplifier U1, the other end of the reset switch K1 is connected to the output terminal of the operational amplifier U1; if the reset switch is closed, the electric potential at the output terminal of the operational amplifier U1 is equal to the electric potential at the negative input terminal, in this case the operational amplifier changes from the high open-loop gain to the amplification of an amplification factor, and the output decreases quickly and the electric circuit is thus reset; but if the reset switch K1 is opened, the electric circuit is again shut;
C:
on the base of B, a back coupling resistor R_{g} and a unipolar toggle switch SW1 are added, such that the flux-locked-loop has the operating point setup function, wherein the unipolar toggle switch comprises three ends for connection, wherein the end 3 is defined as the fixed unipolar connection port, the end 1 is defined as the first contact connection and the end 2 is defined as the second contact connection; the fixed unipolar connection port of the SW1 is connected to the output terminal of the operational amplifier U1, a connection port at the end 1 of the SW1 is connected to one end of the resistor R_{g}, the other end of R_{g} is connected to the negative input terminal of the operational amplifier U1, a connection port at the end 2 of the SW1 is connected to one end of the back coupling resistor R_{f}, the other end of the back coupling resistor R_{f} is connected to the back coupling coil L1; if the unipolar toggle switch SW1 has got a separated second contact connection and a switched on first contact connection, the resistor R_{g} will get into contact with the output terminal of the operational amplifier U1, in this case the flux-locked-loop is in no-load operation and the operational amplifier U1 is in the operational mode of proportional amplification, the voltage signals of the SQUID are thus proportionally amplified, on the base of determining the output voltage V_{f} of the operational amplifier it is possible to obtain a characteristic curve of the flux-voltage-transmission and on the base of this the operating point of the SQUID and the bias current and the bias voltage can be adjusted; after having set the bias current and the bias voltage to the best values, the unipolar toggle switch SW1 will have the first contact connection separated and the second contact connection switched on, such that the output terminal of the operational amplifier U1 will be connected to the back coupling resistor R_{f}, in this case the output of the flux-locked-loop will be shut in the way of "close loop";
**2) that** one of the three following forms D, E and F has to be selected for the connection type with the negative input terminal:
∘ concerning the connection type D the voltage signal of the SQUID of the connection type A is applied to the negative input terminal of the operational amplifier U1 and the bias voltage signal is applied to the positive input terminal of the operational amplifier, all the other components will be connected like in connection type A;
∘ concerning the connection type E the voltage signal of the SQUID of the connection type B is applied to the negative input terminal of the operational amplifier U1 and the bias voltage signal is applied to the positive input terminal of the operational amplifier, all the other components will be connected like in connection type B;
∘ concerning the connection type F the voltage signal of the SQUID of the connection type C is applied to the negative input terminal of the operational amplifier U1 and the bias voltage signal is applied to the positive input terminal of the operational amplifier, all the other components will be connected like in connection type C.

10. A SQUID magnetic field sensor according to claim 9, **characterized in that** the magnetic field sensor is adapted such that
(1) in case of a connection type with the positive or negative input terminal, the positive voltage source +Vs is comprised in the range of +5V through +15V and the corresponding negative voltage source -Vs is comprised in the range of -5V through -15V;
(2) in the SQUID bias current control circuit B1 the value of the resistor between the ends 1 and 2 of the potentiometer is comprised between 10K Ohm and 100K Ohm; the resistor R₁ is comprised between 50K Ohm and 200 K Ohm; thanks to the setting of the adjustable potentiometer R_{A1} a bias direct current can be generated which is comprised within the range of 160uA;
(3) in the SQUID bias voltage control circuit B2 the bias voltage signal is set in a range comprised between -100uV and +100uV; the resistor R₃ is comprised between 1 Ohm and 10 Ohm, the resistor R₂ is comprised between 10K Ohm and 100K Ohm;
(4) the voltage noise of the operational amplifier is about 1nV/√Hz, the open loop gain is higher than 120dB, the amplification bandwidth product is higher than 10MHz;
(5) the back coupling resistor R_{f} is comprised between 100 Ohm and 10K Ohm.

11. A SQUID magnetic field sensor according to claim 10, **characterized in that** AD797 from the American company ADI or LT1028 from the company Linear Technology shall be selected for the low-noise operational amplifier.

## Revendications

1. Capteur de champ magnétique SQUID comprenant un amplificateur opérationnel unique à faible bruit pour amplifier un signal de tension du SQUID à la manière d'une boucle ouverte, dans lequel le capteur de champ magnétique est adapté de sorte qu'une résistance de rétroaction et une bobine de rétroaction sont directement actionnées par moyen d'une valeur de sortie que l'amplificateur opérationnel unique émet à la manière d'une boucle ouverte, **caractérisé en ce qu'**il y a une autre résistance de rétroaction (R_{g}) et un commutateur unipolaire (SW1), le terminal de raccordement fixe et unipolaire du commutateur (SW1) étant relié au terminal de sortie de l'amplificateur opérationnel (U1), un premier terminal de raccordement du commutateur (SW1) étant relié à une extrémité de l'autre résistance de rétroaction (R_{g}), un deuxième terminal de raccordement du commutateur (SW1) étant relié à une extrémité de la résistance de rétroaction, dont l'autre extrémité est reliée à la bobine de rétroaction (L1), l'autre extrémité de l'autre résistance de rétroaction (R_{g}) étant reliée au terminal d'entrée négatif de l'amplificateur opérationnel (U1).

2. Capteur de champ magnétique SQUID selon la revendication 1, **caractérisé en ce qu'**il n'y a pas d'intégrateur pour intégrer des signaux de sortie d'un préamplificateur.

3. Capteur de champ magnétique SQUID selon la revendication 1 ou la revendication 2, **caractérisé en ce que** l'amplificateur opérationnel est un amplificateur opérationnel à faible bruit et fonctionnant de manière bipolaire, lequel amplificateur opérationnel comprend deux entrées pour des signaux de tension, à savoir une entrée positive et une entrée négative, et l'amplificateur opérationnel comprend une sortie pour des signaux de tension amplifiés.

4. Capteur de champ magnétique SQUID selon la revendication précédente, **caractérisé en ce que** la sortie de tension du SQUID est appliquée à une entrée de l'amplificateur opérationnel et une sortie de tension de polarisation est appliquée à l'autre entrée de l'amplificateur opérationnel.

5. Capteur de champ magnétique SQUID selon l'une des revendications précédentes, **caractérisé en ce qu'**une extrémité de la résistance de rétroaction (R_{f}) est reliée à la sortie de l'amplificateur opérationnel et l'autre extrémité de la résistance de rétroaction (R_{f}) est reliée à la bobine de rétroaction (L1).

6. Capteur de champ magnétique SQUID selon l'une des revendications précédentes, **caractérisé en ce qu'**un circuit de commande de courant de polarisation de SQUID (B1) est présent, à l'aide duquel un courant de polarisation, qui passe à deux contacts Josephson, peut être introduit dans le SQUID, le courant de polarisation étant ajustable.

7. Capteur de champ magnétique SQUID selon l'une des revendications précédentes, **caractérisé en ce qu'**il y a un interrupteur de remise à zéro (K1), dans lequel une extrémité de l'interrupteur de remise à zéro est reliée au terminal d'entrée négatif de l'amplificateur opérationnel et l'autre extrémité de l'interrupteur de remise à zéro est reliée au terminal de sortie de l'amplificateur opérationnel.

8. Capteur de champ magnétique SQUID selon la revendication 1, **caractérisé en ce que** le capteur de champ magnétique est adapté de sorte que la SQUID-FLL comprend deux types de connexion suivants avec l'amplificateur opérationnel unique :
1) le type de connexion avec le terminal d'entrée positif: un courant de polarisation I_{b} fourni par une source de courant de polarisation est introduit dans le SQUID et un signal de tension du SQUID est appliqué au terminal d'entrée positif de l'amplificateur opérationnel ; la tension de polarisation V_{b} est appliquée au terminal d'entrée négatif de l'amplificateur opérationnel, le terminal de sortie de l'amplificateur opérationnel est relié à une extrémité de la résistance de rétroaction R_{f} et l'autre extrémité de la résistance de rétroaction est reliée à la bobine de rétroaction, qui est couplée au SQUID par moyen d'une réactance inductive, et un courant est généré **en ce que** la tension de sortie de l'amplificateur opérationnel fait fonctionner la résistance de rétroaction R_{f}, un flux magnétique de rétroaction est généré par la réactance inductive M_{f} entre la bobine de rétroaction et le SQUID et ainsi la boucle fermée de flux (flux-locked-loop) est formée ;
2) le type de connexion avec le terminal d'entrée négatif : un courant de polarisation I_{b} fourni par une source de courant de polarisation est introduit dans le SQUID et un signal de tension du SQUID est appliqué au terminal d'entrée négatif de l'amplificateur opérationnel ; la tension de polarisation V_{b} est appliquée au terminal d'entrée positif de l'amplificateur opérationnel, le terminal de sortie de l'amplificateur opérationnel est relié à une extrémité de la résistance de rétroaction R_{f} et l'autre extrémité de la résistance de rétroaction est reliée à la bobine de rétroaction, qui est couplée au SQUID par moyen d'une réactance inductive, et un courant est généré **en ce que** la tension de sortie de l'amplificateur opérationnel fait fonctionner la résistance de rétroaction R_{f}, un flux magnétique de rétroaction est généré par la réactance inductive M_{f} entre la bobine de rétroaction et le SQUID et ainsi la boucle fermée de flux (flux-locked-loop) est formée.

9. Capteur de champ magnétique SQUID selon la revendication 8, **caractérisé en ce :**
**1) que** le capteur de champ magnétique est adapté de sorte qu'il faut sélectionner un des trois types de connexion suivants A, B et C pour les types de connexion avec le terminal d'entrée positif :
A :
∘ les sources d'alimentation +Vs et -Vs : une alimentation électrique bipolaire est utilisée pour l'alimentation du circuit électrique entier, à savoir une source de tension positive est appliquée au terminal positif +Vs et une source de tension négative est appliquée au terminal négatif -Vs ;
∘ le circuit de commande de courant de polarisation de SQUID B1 : il sert à introduire un courant de polarisation, qui passe à deux contacts Josephson du SQUID, et grâce à l'ajustement du courant de polarisation introduit dans le SQUID. le SQUID comprend la meilleure propriété de conversion de flux magnétique en tension ; concernant le potentiomètre R_{A1} ajustable dans le circuit de commande de courant de polarisation il s'agit d'un composant de résistance ajustable comprenant trois extrémités, dans lequel la valeur de la résistance entre les extrémités 1 et 2 du potentiomètre est fixe et l'extrémité 3 du potentiomètre est une borne de contact déplaçable sur le composant de résistance ajustable, les extrémités 1 et 2 du potentiomètre R_{A1} sont chacune mises sous tension par la source de tension positive +Vs et la source de tension négative -Vs ; à l'extrémité 3 du potentiomètre R_{A1} une tension partielle est émise via une résistance dans le potentiomètre, cette tension est ajustable par le changement de la position de la borne de contact déplaçable du potentiomètre, le terminal de sortie pour émettre cette tension est commuté avec une extrémité de la résistance R₁ et l'autre extrémité de la résistance R₁ est connectée en série avec le SQUID ;
∘ le circuit de commande de courant de polarisation de SQUID B2 : il sert à générer une tension ajustable, qui est appliquée au terminal négatif de l'amplificateur opérationnel, grâce à l'ajustement cette tension devient égale à la tension continue dans le point de fonctionnement du SQUID, de sorte qu'il est mis à zéro dans le point de fonctionnement, concernant le potentiomètre R_{A2} ajustable dans le circuit de commande de courant de polarisation il s'agit d'un composant de résistance ajustable comprenant trois extrémités, dans lequel la valeur de la résistance entre les extrémités 1 et 2 du potentiomètre est fixe et est de préférence comprise entre 10K Ohm et 100K Ohm, les extrémités 1 et 2 du potentiomètre R_{A2} sont chacune mises sous tension par la source de tension positive +Vs et la source de tension négative -Vs ; à l'extrémité 3 du potentiomètre R_{A2} une tension partielle est émise via une résistance dans le potentiomètre, le terminal de sortie pour émettre cette tension est commuté avec une extrémité de la résistance R₃ et l'autre extrémité de la résistance R₃ est connectée en série avec une extrémité de la résistance R₂, l'autre extrémité de la résistance R₂ est reliée à la masse ; la tension partielle, qui a baissé à la résistance, est émise comme le signal de tension de polarisation V_{b} à un point de liaison entre la résistance R₂ et la résistance R₃ ;
∘ le composant SQUID SQ1 : comme SQ1 on peut utiliser un DC-SQUID approprié aux températures basses, qui fonctionne à la température de l'ammoniac liquide de 4,2K, ou un DC-SQUID approprié aux températures élevées, qui fonctionne à la température de l'ammoniac liquide de 77K ; SQ1 est un composant ayant deux connexions, l'une connexion est reliée au terminal d'entrée positif de l'amplificateur opérationnel et simultanément au terminal de sortie de courant du circuit de commande de courant de polarisation B1, l'autre connexion du SQUID est reliée à la masse ;
∘ la bobine de rétroaction L1 : elle est une bobine couplée de façon inductive au SQUID, le courant généré dans le circuit de rétroaction est converti en le flux magnétique de rétroaction par moyen de la bobine de rétroaction, lequel flux magnétique de rétroaction est couplé au SQUID, ainsi un flux magnétique de suppression est formé ; une extrémité de la bobine de rétroaction L1 est reliée à la résistance R_{f} et l'autre extrémité de la bobine de rétroaction L1 est reliée à la masse ;
∘ l'amplificateur opérationnel U1 : un amplificateur opérationnel à faible bruit et fonctionnant de manière bipolaire comprend deux entrées pour des signaux de tension, à savoir un terminal d'entrée positif et un terminal d'entrée négatif ainsi qu'un terminal de sortie pour les signaux de tension amplifiés ; la sortie de tension du SQUID est appliquée au terminal d'entrée positif de l'amplificateur opérationnel et la sortie de la tension de polarisation est appliquée au terminal d'entrée négatif de l'amplificateur opérationnel, le terminal de sortie de l'amplificateur opérationnel sert aussi comme terminal de sortie du capteur entier et est simultanément relié à la résistance de rétroaction R_{f} ;
∘ la résistance de rétroaction R_{f} : une extrémité de la résistance de rétroaction R_{f} est reliée au terminal de sortie de l'amplificateur opérationnel U1 et l'autre extrémité est reliée à la bobine de rétroaction L1 ; la tension de sortie de l'amplificateur opérationnel est convertie en un courant de rétroaction par moyen de la résistance de rétroaction R_{f}, lequel courant de rétroaction est introduit dans la bobine de rétroaction et ainsi un flux magnétique de rétroaction est généré ;
B :
sur la base de A, un interrupteur de remise à zéro K1 est ajouté pour obtenir la fonction de remise à zéro ; une extrémité de l'interrupteur de remise à zéro K1 est reliée au terminal d'entrée négatif de l'amplificateur opérationnel U1, l'autre extrémité de l'interrupteur de remise à zéro K1 est reliée au terminal de sortie de l'amplificateur opérationnel U1 ; si l'interrupteur de remise à zéro est fermé, le potentiel électrique au terminal de sortie de l'amplificateur opérationnel U1 sera égale au potentiel électrique au terminal d'entrée négatif, dans ce cas l'amplificateur opérationnel changera de l'amplification élevée de circuit ouvert à l'amplification d'un facteur d'amplification, et la sortie diminue vite et le circuit électrique est ainsi remis à zéro, mais si l'interrupteur de remise à zéro K1 est ouvert, le circuit électrique sera fermé de nouveau ;
C :
sur la base de B, une résistance de rétroaction Rg et un commutateur unipolaire SW1 sont ajoutés, de sorte que la boucle fermée de flux (flux-locked-loop) a la fonction de réglage du point de fonctionnement, le commutateur unipolaire comprenant trois extrémités destinées à la connexion, l'extrémité 3 étant définie comme terminal de raccordement fixe et unipolaire , l'extrémité 1 étant définie comme première borne de contact et l'extrémité 2 étant définie comme deuxième borne de contact ; le terminal de raccordement fixe et unipolaire du SW1 est relié au terminal de sortie de l'amplificateur opérationnel U1, un terminal de raccordement à l'extrémité 1 du SW1 est relié à une extrémité de la résistance R_{g}, l'autre extrémité de R_{g} est reliée au terminal d'entrée négatif de l'amplificateur opérationnel U1, un terminal de raccordement à l'extrémité 2 du SW1 est reliée à une extrémité de la résistance de rétroaction R_{f}, l'autre extrémité de la résistance de rétroaction R_{f} est reliée à la bobine de rétroaction L1, si le commutateur unipolaire SW1 comprend une deuxième borne de contact séparée et une première borne de contact activée, la résistance R_{g} sera mise en contact avec le terminal de sortie de l'amplificateur opérationnel U1, dans ce cas la boucle fermée de flux est en mode d'un circuit ouvert et l'amplificateur opérationnel U1 est en mode opérationnel de l'amplification proportionnelle, les signaux de tension du SQUID sont ainsi amplifiés de manière proportionnelle, sur la base d'une détermination de la tension de sortie V_{f} de l'amplificateur opérationnel U1 il est possible d'obtenir une courbe caractéristique de la transmission de tension-flux et à l'aide de celle-ci le point de fonctionnement du SQUID et le courant de polarisation et la tension de polarisation peuvent être ajustés ; après avoir ajusté le courant de polarisation et la tension de polarisation aux meilleurs valeurs, le commutateur unipolaire SW1 aura la première borne de contact séparée et la deuxième borne de contact activée, de sorte que le terminal de sortie de l'amplificateur opérationnel U1 est relié à la résistance de rétroaction R_{f}, dans ce cas la sortie de la boucle fermée de flux sera fermée à la manière de « close loop » (boucle fermée),
**2) qu'**une des trois formes suivantes D, E et F doit être sélectionnée pour le type de connexion avec le terminal d'entrée négatif :
∘ quant au type de connexion D le signal de tension du SQUID du type de connexion A est appliqué au terminal d'entrée négatif de l'amplificateur opérationnel U1 et le signal de tension de polarisation est appliqué au terminal d'entrée positif de l'amplificateur opérationnel, et les autres composants seront reliés à la manière du type de connexion A ;
∘ quant au type de connexion E le signal de tension du SQUID du type de connexion B est appliqué au terminal d'entrée négatif de l'amplificateur opérationnel U1 et le signal de tension de polarisation est appliqué au terminal d'entrée positif de l'amplificateur opérationnel, et les autres composants seront reliés à la manière du type de connexion B ;
∘ quant au type de connexion F le signal de tension du SQUID du type de connexion C est appliqué au terminal d'entrée négatif de l'amplificateur opérationnel U1 et le signal de tension de polarisation est appliqué au terminal d'entrée positif de l'amplificateur opérationnel, et les autres composants seront reliés à la manière du type de connexion C.

10. Capteur de champ magnétique SQUID selon la revendication 9, **caractérisé en ce que** le capteur de champ magnétique est adapté de sorte que :
(1) en cas d'un type de connexion avec le terminal d'entrée positif ou négatif, la source de tension positive +Vs est comprise dans la gamme de +5V à +15V et la source de tension négative correspondante -Vs est comprise dans la gamme de -5V à -15V ;
(2) dans le circuit de commande de courant de polarisation du SQUID B1 la valeur de la résistance entre les extrémités 1 et 2du potentiomètre est comprise entre 10K Ohm et 100K Ohm ; la résistance R₁ est comprise entre 50K Ohm et 200K Ohm ; grâce au réglage du potentiomètre ajustable RA1 il est possible de générer un courant continu de polarisation qui est au niveau de 160uA ;
(3) dans le circuit de commande de courant de polarisation du SQUID B2 le signal de tension de polarisation est ajusté dans une gamme comprise entre -100uV et +100uV, la résistance R₃ est comprise entre 1 Ohm et 10 Ohm, la résistance R₂ est comprise entre 10K Ohm et 100K Ohm ;
(4) le bruit de tension de l'amplificateur opérationnel est environ 1nV/√Hz, l'amplification de circuit ouvert est supérieure à 120dB, le produit de gamme large d'amplification est supérieur à 10MHz ;
(5) la résistance de rétroaction R_{f} est comprise entre 100 Ohm et 10K Ohm.

11. Capteur de champ magnétique SQUID selon la revendication 10, **caractérisé en ce qu'**il faut sélectionner AD797 de l'entreprise américaine ADI ou LT1028 de l'entreprise Linear Technology pour l'amplificateur opérationnel à faible bruit.
